# EUROPÄISCHE PATENTSCHRIFT

(11) **EP 2 974 863 B1**
(45) Veröffentlichungstag und Bekanntmachung des Hinweises auf die Patenterteilung: **19.10.2016**
(21) Anmeldenummer: 14177588.2
(22) Anmeldetag: 18.07.2014
(51) Int. Cl.: B41C 1/10

(54) **Vorrichtung und Verfahren zum Herstellen einer Druckplatte für den wasserlosen Offsetdruck**
Device and method for producing a printing plate for dry offset printing
Dispositif et procédé de fabrication d'une plaque d'impression pour l'impression offset sans eau

(43) Veröffentlichungstag der Anmeldung: 20.01.2016
(73) Patentinhaber: Könings GmbH, 41751 Viersen-Dülken (DE)
(72) Erfinder: Sieger, Gert, 70619 Stuttgart (DE)
(74) Vertreter: Michalski Hüttermann & Partner Patentanwälte mbB

(56) Entgegenhaltungen:
- JP-A- 2000 194 125
- JP-A- 2010 230 833

## Beschreibung

Die Erfindung betrifft eine Vorrichtung und ein Verfahren zum Herstellen einer Druckplatte für den wasserlosen Offsetdruck. Die vorliegende Erfindung betrifft insbesondere eine verbesserte Entwicklerstation für die Entwicklung einer zuvor belichteten Druckplatten-Vorstufe im Rahmen der Herstellung einer Druckplatte für den wasserlosen Offsetdruck.

Offsetdruckverfahren sind in weiten Teilen der Technik hinlänglich bekannt. Eine besonders vorteilhafte Form des Offsetdrucks bietet der sogenannte wasserlose Offsetdruck. Bei einem derartigen Verfahren wird in Abgrenzung zu einem herkömmlichen Offsetdruckverfahren, bei welchem zwei getrennt wirkende Medien, eine Druckfarbe und ein Feuchtmittel, verwendet werden, mit nur einem Medium, der Farbe, gearbeitet. Dadurch bietet dieses Verfahren insbesondere Vorteile in prozesstechnischer Hinsicht wie auch in ökologischer Hinsicht. Darüber hinaus lassen sich durch den wasserlosen Offsetdruck besonders kontrastreiche und damit qualitativ hochwertige gedruckte Strukturen erzeugen.

Im Detail findet bei einem wasserlosen Offsetdruckverfahren ein Flachdruckverfahren mit indirektem Farbauftrag Anwendung, wobei druckende Positionen einer geeigneten Druckplatte mit Farbe benetzt werden, die bildfreien beziehungsweise nicht druckenden Positionen der Druckplatte jedoch frei von Farbe bleiben. Dies kann beispielsweise realisierbar sein durch eine entsprechende Beschichtung der Druckplatten. So können beispielsweise die druckenden Positionen auf der Druckplatte unbeschichtet sein oder derart beschichtet, dass Farbe aufgenommen beziehungsweise haften kann, wohingegen nicht druckende Positionen derart beschichtet oder unbeschichtet sein können, dass die Farbe abgestoßen wird. Hierzu kann beispielsweise eine Silikonbeschichtung dienen.

Bei der Herstellung von derartigen Druckplatten insbesondere als Negativplatten ist es bekannt, dass in die Beschichtung Aussparungen eingefügt werden, wobei entsprechendes Material aus einer Beschichtung entfernt wird. Dadurch kann eine unter der Beschichtung vorliegende Fläche in einem Druckprozess für die verwendete Farbe zugänglich werden und somit die druckenden Bereiche beziehungsweise Positionen definieren. Bei einem derartigen Prozess ist es grundsätzlich bekannt, dass nach einer Vorbehandlung, welche im Wesentlichen das Belichten, etwa umfassend ein Bestrahlen der Beschichtung und ein anschließendes Aufquellen des Beschichtungsmaterials mittels eines Quellmittels, das vorbehandelte Beschichtungsmaterial aus den Aussparungen mittels Bürsten entfernt wird. Dies erfolgt in einer sogenannten Entwickler-Stufe. Dabei wird die Behandlung durch Bürsten in der Regel in einem mehrstufigen Prozess mit einer Mehrzahl an aufeinanderfolgenden Bürsten beziehungsweise Bürsteneinheiten durchgeführt.

Somit ist das Herstellen der Druckplatten ein Prozess, der oftmals eine Vielzahl von aufeinanderfolgenden Prozessschritten umfasst, was in Abhängigkeit der verwendeten Schritte vergleichsweise kostenintensiv und aufwändig sein kann.

Das Dokument JP-A-2000 194 125 offenbart eine Vorrichtung zum Herstellen einer Druckplatte (13) für den wasserlosen Offsetdruck, aufweisend eine Bürsteinheit (24) zum bürstenden Herauslösen von herauszulösenden Bereichen (14) einer Beschichtung einer Druckplatten-Vorstufe, wobei die Bürsteinheit (24) wenigstens eine Bürste (26) mit einer Vielzahl von Borsten (28) aufweist (siehe Absatz [0001] und Anspruch 1). Die Borsten sind aus Polymere ausgestaltet (siehe Absatz [0021]).

Es ist daher die Aufgabe der vorliegenden Erfindung, eine Vorrichtung zum Herstellen einer Druckplatte für den wasserlosen Offsetdruck beziehungsweise ein Verfahren zum Herstellen einer Druckplatte für den wasserlosen Offsetdruck zu schaffen, welche beziehungsweise welches eine besonders kostengünstige und/oder effektive Herstellung der Druckplatten ermöglichen kann.

Diese Aufgabe wird erfindungsgemäß durch eine Vorrichtung zum Herstellen einer Druckplatte für den wasserlosen Offsetdruck gemäß Anspruch 1 gelöst. Die Aufgabe wird ferner durch ein Verfahren zum Herstellen einer Druckplatte für den wasserlosen Offsetdruck gemäß Anspruch 7 gelöst. Bevorzugte Ausgestaltungen sind in den Unterarisprüchen, in der nachfolgenden Beschreibung und in den Figuren angegeben, wobei weitere Merkmale einzeln oder in beliebiger Kombination einen Gegenstand der Erfindung darstellen können, sofern sich aus dem Kontext nicht explizit das Gegenteil ergibt.

Gemäß der vorliegenden Erfindung wird eine Vorrichtung zum Herstellen einer Druckplatte für den wasserlosen Offsetdruck vorgeschlagen. Die Vorrichtung weist eine Bürsteinheit zum bürstenden Herauslösen von herauszulösenden Bereichen einer Beschichtung einer Druckplatten-Vorstufe auf, wobei die Bürsteinheit wenigstens eine Bürste mit einer Vielzahl von Borsten aufweist. Dabei ist es vorgesehen, dass die Borsten aus Silikon ausgestaltet sind und eine noppenartige Struktur aufweisen.

Eine vorbeschriebene Vorrichtung ermöglicht es auf einfache Weise, das Herstellungsverfahren für Druckplatten für den wasserlosen Offsetdruck besonders effektiv und kostengünstig zu gestalten.

Unter herauszulösenden Bereichen einer Beschichtung können im Sinne der vorliegenden Erfindung insbesondere derartige Bereiche verstanden werden, aus welchen durch die Behandlung mit der Bürste Material der Beschichtung herausgelöst werden soll, um so Aussparungen in der Beschichtung, insbesondere entlang der gesamten Beschichtungstiefe, zu erzeugen. Dazu sind die herauszulösenden Bereiche der Beschichtung insbesondere vorbehandelt, etwa durch eine Bestrahlung und/oder ein Aufquellen, wie dies gemäß dem Stand der Technik grundsätzlich bekannt ist und nachstehend mit Bezug auf das Verfahren im Detail beschrieben wird.

Unter einer Druckplatten-Vorstufe kann ferner im Sinne der vorliegenden Erfindung insbesondere verstanden werden ein Gebilde, aus welchem in einem, etwa nur der bürstenden Behandlung, oder in mehreren Schritten eine im wasserlosen Offsetdruck verwendbare Druckplatte erzeugbar ist. Somit ist eine Druckplatten-Vorstufe insbesondere ein Zwischenprodukt in der Herstellung von Druckplatten, wie dies nachfolgend mit Bezug auf das Verfahren im Detail beschrieben wird. Dabei kann die Druckplatten-Vorstufe bereits die endgültigen Dimensionen beziehungsweise Ausmaße aufweisen, oder sie kann eine Größe aufweisen, die eine Mehrzahl von anzuwendenden Druckplatten aufweist und in einem späteren Verfahrensschritt noch vereinzelt werden kann.

Die vorbeschriebene Vorrichtung zum Herstellen einer Druckplatte für den wasserlosen Offsetdruck umfasst somit eine Bürsteinheit zum bürstenden Herauslösen von herauszulösenden Bereichen einer Beschichtung einer Druckplatten-Vorstufe. Die Vorrichtung kann somit lediglich dem bürstenden Behandeln der Druckplatten-Vorstufe dienen und als solche beispielsweise ein Teil beziehungsweise ein Modul eines modularen Aufbaus einer Gesamtanlage zur Herstellung von Druckplatten für den wasserlosen Offsetdruck sein. Alternativ kann die Vorrichtung selbst weitere Bearbeitungseinheiten umfassen, wie dies nachstehend mit Bezug auf das Verfahren im Detail beschrieben ist.

Die Bürsteinheit umfasst wenigstens eine Bürste, welche dem bürstenden Bearbeiten der Druckplatten-Vorstufe dient. Die Bürste weist dabei in an sich bekannter Weise eine Vielzahl von Borsten auf, welche die Druckplattenvorstufe bearbeiten beziehungsweise behandeln. Dabei ist es vorgesehen, dass die Borsten aus Silikon ausgestaltet sind und eine noppenartige Struktur aufweisen. Dabei kann grundsätzlich jedes Silikonmaterial Verwendung finden. Insbesondere durch die vorbeschriebene Ausgestaltung der Bürste beziehungsweise der Borsten kann ein besonders effektives Bearbeiten der Druckplatten-Vorstufe und damit ein besonders effektives Herstellen von Druckplatten für den wasserlosen Offsetdruck realisiert werden.

Im Detail dient die Bürsteinheit dem Bearbeiten einer Druckplatten-Vorstufe, insbesondere um Aussparungen, welche in einer Beschichtung der Druckplatte vorgesehen sein sollen, auszuformen. Dies kann insbesondere durch eine bürstende Behandlung von herauszulösenden Bereichen der Beschichtung realisierbar sein, wobei die herauszulösenden Bereiche in einem vorhergehenden Schritt vorbehandelt wurden. Somit dienen die Bürsten dazu, das Material herauszulösen oder in anderen Worten die zu bildenden Aussparungen durch Herauslösen des Materials der herauszulösenden Bereiche auszubilden beziehungsweise das in der auszubildenden Aussparung vorliegende Material zu entfernen. Dabei kann es sich bei dem Material beispielsweise um belichtetes beziehungsweise aufgeschwemmtes Beschichtungsmaterial handeln, wie dies nachfolgend mit Bezug auf das Verfahren im Detail beschrieben wird. Somit dient die Vorrichtung insbesondere als Entwicklungseinheit, die einer Belichtungseinheit nachgeschaltet werden kann, wie dies nachfolgend für das Verfahren im Detail beschrieben ist.

Dadurch, dass die Borsten aus Silikon beziehungsweise einem Silikonmaterial (Poly(organo)siloxan) ausgebildet sind, wobei die Borsten beispielsweise aus Silikon bestehen können, können die Borsten zum Einen besonders kostengünstig herstellbar sein, so dass die Vorrichtung besonders kostengünstig ausgestaltet werden kann. Darüber hinaus ist Silikon für die gewünschte Verwendung ein sehr stabiles Material, so dass die Borsten eine effektive Herstellung der Druckplatten mit einer besonders guten Langlebigkeit vereinen können. Schließlich kann eine Verwendung von Silikon insbesondere dann von Vorteil sein, wenn die zu bearbeitende Druckplatte beziehungsweise die zu behandelnde Beschichtung ebenfalls Silikon umfasst und damit grundsätzlich dann, wenn das Material der Beschichtung der Druckplatten-Vorstufe das gleiche ist, wie das der Borsten. Denn in dieser Ausgestaltung kann ein Bearbeiten der Druckplatten-Vorstufe besonders schonend sein, da die Gefahr nicht besteht oder zumindest signifikant reduziert werden kann, dass die Beschichtung beziehungsweise Kanten derselben bei einem Bearbeiten der Druckplatten-Vorstufe beschädigt werden. Dadurch kann besonders sichergesellt werden, dass eine qualitativ besonders hochwertige Druckplatte erzeugt wird, welche ein wasserloses Offsetduuckverfahren mit einem besonders guten Ergebnis, wie etwa mit einem besonders hohen Kontrast, einer gedruckten Struktur ermöglichen kann.

Weiterhin kann ein bürstendes Behandeln der Druckplatten-Vorstufe durch Silikon-Borsten besonders effektiv sein, da durch derartige Borsten das auszutragende Material besonders effektiv entfernbar sein kann. Ohne auf die Therorie festgelegt zu sein wird vermuten, dass Silikonmaterialien eine Oberfläche, insbesondere eine Oberflächenrauigkeit, aufweisen, welche dazu führt, dass ein besonders effektives Herauslösen des Materials ermöglicht werden kann. Denn durch die Rauigkeit können mehrfach gerichtete Reinigungseinwirkungen der Borsten auf das entsprechende Material wirken.

Ferner kann durch die noppenartige Struktur der Borsten und die damit, im Vergleich zu oftmals verwendeten Nylon-Fäden als Borsten, vergrößerte Strukturstabilität ein Herauslösen des entsprechenden Materials besonders effektiv ermöglicht werden. Im Sinne der vorliegenden Erfindung kann dabei unter einer noppenartigen Ausgestaltung insbesondere verstanden werden, dass die Borsten mit Bezug auf Ihre Struktur stabil beziehungsweise selbsttragend sind und somit umlaufend auch bei einem Stillstand der Bürste ihre Form beziehungsweise Struktur im Wesentlichen aufrecht erhalten können.

Somit kann die besonders hohe Effektivität der Herstellung einer Druckplatte für den wasserlosen Offsetdruck durch die vorbeschriebene Vorrichtung in überraschender Weise insbesondere erzeugt werden durch das Vorsehen von aus Silikon geformten noppenartigen Borsten.

Durch die vorbeschriebene Ausgestaltung wird es daher möglich, die Anforderungen an die Bürsteinheit zu reduzieren. In anderen Worten kann es durch die vorbeschriebene Vorrichtung möglich werden, eine geringere Anzahl an Bürsten zu verwenden oder das bürstende Behandeln der Druckplatten-Vorstufe verglichen mit den Vorrichtung aus dem Stand der Technik in einer geringeren Anzahl an Arbeitsschritten durchzuführen, wobei ein verglichen mit dem Stand der Technik zumindest vergleichbarer Löseefekt des herauszulösenden Materials erzielt werden kann.

Ferner kann beispielsweise ein gegebenenfalls durch die Borsten auf die Oberfläche der Druckplatten-Vorstufe ausgeübter Druck aufgrund der besseren Reinigungsleistung beziehungsweise Abtragleistung mit Bezug auf das zu entfernende Material reduziert werden, was ein Behandeln der Druckplatten-Vorstufe durch eine vorbeschriebene Vorrichtung besonders schonend gestalten kann.

Eine derartige Bürste kann dabei besonders einfach und problemlos herstellbar sein, indem beispielsweise eine Noppenmatte, welche als Borsten fungierende Noppen aufweist, um eine Welle gelegt und dort fixiert wird. Eine Noppenmatte ist dabei aus anderen technischen Gebieten, etwa zur Lagerung oder Sterilisierung von Operationsbestecken, weitläufig bekannt.

Somit erlaubt eine vorbeschriebene Vorrichtung zusammenfassend ein besonders effektives, kostengünstiges und/oder einfaches Herstellen von Druckplatten für den wasserlosenlosen Offsetdruck.

In einer bevorzugten Ausgestaltung der vorbeschriebenen Vorrichtung kann es weiterhin vorgesehen sein, dass die Borsten in einer Mehrzahl von in Laufrichtung hintereinander positionierten Reihen angeordnet sind, wobei die Borsten in jeder Reihe zumindest teilweise einen gleichen Abstand zueinander aufweisen, und wobei zwei in Laufrichtung aufeinanderfolgende Reihen axial versetzt sind. Dabei kann der Abstand der Borsten zu einander in jeder Reihe reihenübergreifend gleich sein. In dieser Ausgestaltung kann eine räumlich besonders gute Abdeckung der Bearbeitungspositionen erreicht werden, so dass das Entfernen des herauszulösenden Materials besonders effektiv sein kann. Beispielsweise kann durch eine derartige Ausgestaltung erreicht werden, dass bei einem einmaligen Rotieren der Bürste um 360° im Wesentlichen jeder Punkt der zu bearbeitenden Oberfläche wenigstens einmal, vorzugsweise mehrfach, durch die Bürste bearbeitet wird.

In einer weiteren bevorzugten Ausgestaltung der vorbeschriebenen Vorrichtung kann es weiterhin vorgesehen sein, dass die Borsten eine kegelartige Struktur aufweisen. Insbesondere durch eine kegelartige Struktur kann die Stabilität der Borsten besonders hoch sein, und kann ein Löseeffekt besonders effektiv sein. Dabei kann unter einer kegelartigen Struktur im Sinne der vorliegenden Erfindung insbesondere verstanden werden eine Struktur der Borsten derart, dass diese einen Durchmesser beziehungsweise einen Querschnitt aufweisen, der von ihrem untersten Punkt, wie etwa an dem einer Welle zugewandten Ende, in Richtung der Kegelspitze, also insbesondere in Richtung dem freiliegenden Ende der Borsten, insbesondere kontinuierlich abnimmt. Dabei kann es etwa vorgesehen sein, dass der Kegel an seinem unteren Ende einen Durchmesser von ≥ 2,6mm bis ≤ 3,5mm, beispielsweise 3mm, aufweist, und an seinem oberen Ende einen Durchmesser von ≥ 1,5 bis ≤ 2,5mm, beispielsweise von 2mm, aufweist.

In einer weiteren bevorzugten Ausgestaltung der vorbeschriebenen Vorrichtung kann es weiterhin vorgesehen sein, dass die Borsten eine Shore-A-Härte in einem Bereich von ≥ 50, beispielsweise ≥60, etwa in einem Bereich bis ≤ 80, aufweisen. Insbesondere durch das Verwenden von Borsten mit einer Härte in einem derartigen Bereich kann wiederum ein besonders gründliches Herauslösen beziehungsweise Entfernen von Material aus der Aussparung verbunden werden mit einer besonders schonenden Bearbeitung der Druckplatten-Vorstufe. Dadurch kann in anderen Worten ein besonders effektives und qualitativ hochwertiges Herstellen von Druckplatten miteinander kombiniert werden. Dabei kann die Shore-A-Härte insbesondere ermittelbar sein bei insbesondere 23°C nach DIN EN ISO 868.

In einer weiteren bevorzugten Ausgestaltung der vorbeschriebenen Vorrichtung kann es weiterhin vorgesehen sein, dass die Borsten eine Länge in einem Bereich von ≥ 3mm bis ≤ 20mm aufweisen. Insbesondere in dieser Ausgestaltung können die Borsten eine Stabilität aufweisen, welche einen effektiven Schritt des Herauslösens von herauszulösendem Material ermöglicht, wobei jedoch gleichzeitig ein schonendes Bearbeiten der Beschichtung aufgrund einer ausreichenden Flexibilität ermöglicht werden kann. Beispielsweise können die Borsten eine Länge in einem Bereich von ≥ 5mm bis ≤ 15mm, etwa von 10mm, aufweisen.

In einer weiteren bevorzugten Ausgestaltung der vorbeschriebenen Vorrichtung kann es weiterhin vorgesehen sein, dass die Borsten in einer Anzahl von ≥ 40000/m² bis ≤ 150000/m² vorgesehen sind. Insbesondere in dieser Ausgestaltung mit einer derartigen Verteilungsdichte der Borsten kann eine hohe Abdeckung der Oberfläche der Bürste mit Borsten ermöglicht werden, so dass eine besonders umfassende Behandlung der Beschichtung und damit ein besonders effektives Herauslösen von herauszulösendem Material ermöglicht werden kann. Beispielsweise können die Borsten in einer Anzahl von ≥ 60000/m² bis ≤ 120000/m², etwa von ≥ 80000/m² bis ≤ 100000/m², vorgesehen sein. Dazu kann beispielsweise zum Herstellen einer Bürste eine Noppenmatte verwendet werden, welche bei einer Draufsicht 300/m Borsten in beiden Dimensionen aufweist.

Hinsichtlich weiterer Vorteile und technischer Merkmale der vorbeschriebenen Vorrichtung wird hiermit explizit auf die nachstehenden Ausführungen mit Bezug auf das Verfahren sowie die Verwendung, als auch auf die Figuren sowie die Figurenbeschreibung verwiesen.

Die vorliegende Erfindung betrifft ferner ein Verfahren zum Herstellen einer Druckplatte für den wasserlosen Offsetdruck, aufweisend die Verfahrensschritte:
a) Bereitstellen einer Druckplatten-Vorstufe, welche eine Beschichtung mit in der Beschichtung vorgesehenen herauszulösenden Bereichen aufweist;
b) Einführen der Druckplatten-Vorstufe in eine Bürsteinheit, wobei die Bürsteinheit eine Bürste mit einer Vielzahl von Borsten umfasst, wobei die Borsten aus Silikon ausgestaltet sind und eine noppenartige Struktur aufweisen; und
c) Bürstendes Behandeln der Druckplatten-Vorstufe in der Bürsteneinheit durch die wenigstens eine Bürste zum Herauslösen des herauszulösenden Materials.

Das vorbeschriebene Verfahren schafft eine Möglichkeit, eine Druckplatte für den wasserlosen Offsetdruck besonders kostengünstig und effektiv herstellen zu können. Dabei kann das vorbeschriebene Verfahren insbesondere durchführbar sein unter Verwendung einer Vorrichtung, wie sie vorstehend im Detail beschrieben ist.

Das Verfahren umfasst gemäß Verfahrensschritt a) das Bereitstellen einer Druckplatten-Vorstufe, welche eine Deckschicht mit in der Deckschicht vorgesehenen herauszulösenden Bereichen aufweist. Dieser Verfahrensschritt a) kann in einer Ausgestaltung im Wesentlichen in Einklang sein mit einem grundsätzlich bekannten Verfahren zum Herstellen einer Druckplatte für den wasserlosen Offsetdruck, wie insbesondere einer sogenannten für den Fachmann grundsätzlich bekannten Toray-Platte.

Eine derartige Druckplatten-Vorstufe umfasst beispielsweise einen Träger, der beispielsweise aus Aluminium ausgestaltet ist. Oberhalb des Trägers kann sich eine Schicht befinden, welche insbesondere eine für eine in einem späteren Offsetdruckverfahren verwendete Farbe anziehende Wirkung aufweist beziehungsweise eine Affinität zu dieser Farbe aufweist, so dass bei dem durchzuführenden Druckverfahren die Farbe sich insbesondere im Bereich dieser Schicht anordnen kann. Dabei kann die Schicht etwa in geeigneter Weise an die in einem Offsetdruckverfahren zu verwendende Farbe angepasst sein und beispielsweise als Polymerschicht ausgestaltet sein. Für eine bessere Haftung der Polymerschicht auf dem Träger, beispielsweise, kann optional zwischen Träger und der farbaffinen Schicht, beispielsweise Polymerschicht, weiterhin eine Zwischenschicht, wie insbesondere eine so genannte Primerschicht, vorgesehen sein. Das Material der Zwischenschicht, beziehungsweise der Primer, kann dabei insbesondere an das Material des Trägers sowie an das Material der farbtragenden Schicht, inbesondere Polymerschicht, angepasst sein. Oberhalb der insbesondere farbtragenden Schicht kann wiederum eine Beschichtung vorgesehen sein, welche aus einem Material ausgestaltet ist, das eine für die in dem Druckverfahren verwendete Farbe abstoßende Wirkung aufweist. Beispielsweise kann die Beschichtung eine Silikonbeschichtung sein. Ferner kann diese Beschichtung insbesondere bei der fertiggestellten Druckplatte die äußerste Schicht darstellen und kann somit als Deckschicht bezeichnet werden.

Bei einer vorbeschriebenen Anordnung kann somit die äußerste Beschichtung, wie etwa die Silikonschicht, dazu dienen, die bei einem Offsetdruck verwendete Farbe abzustoßen, wohingegen die darunter liegende Schicht gerade eine Affinität für die Farbe aufweisen kann. Somit sind bei einer fertig gestellten Druckplatte die Bereiche, in denen die Silikonschicht vorliegt, die nicht druckenden Bereiche, wohingegen die Bereiche, an denen die farbtragende Schicht offenliegt beziehungsweise die Aussparungen vorgesehen sind, die druckenden Bereiche sein können, wie dies grundsätzlich für derartige Druckplatten für den wasserlosen Offsetdruck bekannt ist.

Um die insbesondere farbtragende Schicht, welche sich unterhalb der Deckschicht, beispielsweise Silikonbeschichtung, befindet, freizulegen, kann ein Verfahren angewendet werden, bei welchem der vorbeschriebene Aufbau als Negativplatte dient, wie dies grundsätzlich für die Herstellung von Druckplatten bekannt ist. Dazu wird die Negativplatte beziehungsweise insbesondere die Deckschicht zunächst belichtet. Dies kann beispielsweise realisiert werden, indem auf die Deckschicht eine Maske aufgelegt wird, die beispielsweise als Schutzfilm ausgestaltet sein kann. Dieser Schutzfilm ist insbesondere für die verwendete Strahlung, beispielsweise UV-Strahlung oder IR-Strahlung mit einer rein exemplarischen Wellenlänge von 830nm, undurchlässig, so dass bei einer Bestrahlung mit der verwendeten Strahlung sich die Verbindung zwischen der Deckschicht und der darunter liegenden Schicht lösen kann. In diesem Schritt werden somit Aussparungen beziehungsweise deren Ausmaße in der Deckschicht beziehungsweise Beschichtung definiert, was insbesondere durch die Maskierung realisiert wird, da die zu bildendenden Aussparungen einen Umfang beziehungsweise eine Größe aufweisen, welcher beziehungsweise welche durch die Maskierung beziehungsweise durch die Schutzfolie festgelegt wird und haben weiterhin eine Tiefe, welche durch die Dicke der Beschichtung wie etwa der Silikonschicht definiert wird. Zusätzlich kann durch den Einsatz geeigneter Chemikalien beziehungsweise Aufquellmittel das Material innerhalb der Aussparung aufgeschwemmt werden. Hierfür eignet sich als Chemikalie beispielsweise die an sich bekannte Entwickleiflüssigkeit, welche unter dem Namen NP-1 von mehreren Firmen für Toray Platten vertrieben wird, gegebenenfalls unter Temperatureinfluss.

Zusammenfassend kann Verfahrensschritt a) somit die Verfahrensschritte aufweisen: a1) Bestrahlen definierter Bereiche der Beschichtung einer Druckplatten-Vorstufe mit elektromagentischer Strahlung, insbesondere unter Erzeugung der herauszulösenden Bereiche; und a2) Behandeln der bestrahlten Bereiche mit einem Aufquellmittel.

Durch die vorbeschriebenen Verfahrensschritte kann somit Verfahrensschritt a) fertig gestellt sein beziehungsweise kann eine Druckplatten-Vorstufe bereitgestellt werden, welche eine Beschichtung, insbesondere Deckschicht, mit in der Beschichtung vorgesehenen herauszulösenden Bereichen aufweist. Dabei können die herauszulösenden Bereiche insbesondere bei einem Einsatz der Druckplatte in einem wasserlosen Offsetdruckverfahren die druckenden Bereiche darstellen. Es ist für den Fachmann jedoch verständlich, dass Verfahrensschritt a) nicht auf die vorbeschriebenen Prozessschritte beschränkt ist und dass die herauszulösenden Bereiche in Abhängigkeit des Materials der Beschichtung beziehungsweise Deckschicht und dem darunter liegenden Material ebenfalls bei einem Einsatz in einem Druckverfahren die druckenden Bereiche ausbilden können, wohingegen die weiteren Bereiche die nicht druckenden Bereiche ausbilden können.

Gemäß Verfahrensschritt b) umfasst das Verfahren weiterhin das Einführen der Druckplatten-Vorstufe in eine Bürsteinheit, wobei die Bürsteinheit eine Bürste mit einer Vielzahl von Borsten umfasst, wobei die Borsten aus Silikon ausgestaltet sind und eine noppenartige Struktur aufweisen. Somit kann die Bürsteinheit insbesondere ausgestaltet sein, wie es vorstehend mit Bezug auf die Vorrichtung beschrieben ist. Das Einführen der Druckplatten-Vorstufe in die Bürsteinheit kann dabei realisiert werden, indem beispielsweise ein Förderer vorgesehen ist, der die Druckplatten-Vorstufe von einer vorherigen Bearbeitungsstation in die Bürsteinheit beziehungsweise durch diese durch führt.

Wenn die Druckplatten-Vorstufe in die Bürsteinheit eingeführt wurde, erfolgt gemäß Verfahrensschritt c) ein bürstendes Behandeln der Druckplatten-Vorstufe mit der Bürste zum Herauslösen des herauszulösenden Materials. Dieser Verfahrensschritt kann somit insbesondere ein Entwickeln der Druckplatten-Vorstufe sein, indem das herauszulösende Material aus den entsprechenden Bereichen herausgelöst wird und die Aussparungen somit ausgeformt werden, wobei das unter den Aussparungen beziehungsweise unterhalb der Beschichtung, wie insbesondere der Silikonschicht, befindliche Material freigelegt wird. Dabei können die Bürsten insbesondere rotierbar gelagert sein, so dass durch die Borsten der Bürsten bei einer Rotation der Bürsten die Aussparungen durch Herauslösen des herauszulösenden Materials ausgebildet werden.

Darüber hinaus kann es vorgesehen sein, dass Verfahrensschritt c) als Einstufen-Prozess durchgeführt wird, oder dass die Druckplatten-Vorstufe sukzessive mehrfach durch insbesondere rotierende Bürsten behandelt wird. Durch die vorbeschriebene Ausgestaltung der Borsten kann das Entfernen von Beschichtungsmaterial, welches wie vorstehend erläutert insbesondere bestrahlt und aufgeschwemmt sein kann, besonders effektiv sein, so dass bevorzugt auf eine Mehrzahl an Bürsteneinheiten verzichtet werden kann oder deren Anzahl zumindest deutlich reduziert sein kann. Dadurch können entsprechende Druckplatten- für den wasserlosen Offsetdruck besonders kostengünstig ausgestaltet werden.

Im Anschluss an Verfahrensschritt c) kann das Verfahren grundsätzlich beendet sein, oder die so behandelte Druckplatten-Vorstufe beziehungsweise die nunmehr erhalten eine Druckplatten kann in einem oder mehreren Schritten zum Beenden des Herstellungsverfahrens und somit zum vollständigen Herstellen der Druckplatte weiterbehandelt werden. Beispielsweise kann ein Nachbehandeln erfolgen, indem die Aussparungen mit einer Farbe behandelt werden und/oder mit einem Material, welches die farbtragenden Eigenschaften in einem Druckverfahren weiter verbessert, wie dies für derartige Verfahren grundsätzlich bekannt ist.

In einer weiteren vorteilhaften Ausgestaltung des vorbeschriebenen Verfahrens kann die Bürste während Verfahrensschritt c) axial, insbesondere mit Bezug auf die Bürstenachse, bewegt werden. In dieser Ausgestaltung findet somit nicht nur ein Rotieren der Bürste statt, sondern es wird ferner eine Bewegung der Bürste in einer zu der Laufrichtung der Borsten rechtwinkligen. Ebene durchgeführt. Dadurch kann Verfahrensschritt c) besonders effektiv durchgeführt werden, wodurch beispielsweise ein für die zu bearbeitende Oberfläche besonders schonender Verfahrensschritt erlaubt werden kann. Weiterhin kann es möglich sein, dass beispielsweise die Anzahl der Bürsteinheiten weiter reduziert werden kann.

Hinsichtlich weiterer Vorteile und technischer Merkmale des vorbeschriebenen Verfahrens wird hiermit explizit auf die vorstehenden Ausführungen mit Bezug auf die Vorrichtung sowie die nachfolgenden Ausführungen mit Bezug auf die Verwendung, als auch auf die Figuren sowie die Figurenbeschreibung verwiesen.

Die vorliegende Erfindung betrifft ferner die Verwendung einer Bürste mit einer Vielzahl an Borsten zum bürstenden Behandeln einer Druckplatten-Vorstufe zum Entfernen von Material aus herauszulösenden Bereichen einer Beschichtung im Rahmen einer Herstellung von Druckplatten für den wasserlosen Offsetdruck, wobei eine Bürste verwendet wird, deren Borsten aus Silikon ausgestaltet sind und eine noppenartige Struktur aufweisen.

Zusammenfassend erlaubt die vorbeschriebene Verwendung eine besonders kostengünstige und effektive Herstellung von Druckplatten für den wasserlosen Offsetdruck.

Hinsichtlich weiterer Vorteile und technischer Merkmale der vorbeschriebenen Verwendung wird hiermit explizit auf die vorstehenden Ausführungen mit Bezug auf die Vorrichtung und das Verfahren, als auch auf die Figuren sowie die Figurenbeschreibung verwiesen.

Im Folgenden wird die Erfindung anhand eines bevorzugten Ausführungsbeispiels anhand der beiliegenden Figuren erläutert, wobei explizit darauf hingewiesen wird, dass der erfindungsgemäße Gegenstand nicht auf das beschriebene Ausführungsbeispiel beschränkt ist.

Es zeigen:
Fig. 1 einen ersten, optionalen Teilbereich einer Ausgestaltung einer Vorrichtung gemäß der vorliegenden Erfindung;
Fig. 2 einen weiteren Teilbereich einer Ausgestaltung einer Vorrichtung gemäß der vorliegenden Erfindung;
Fig. 3 einen dritten, optionalen Teilbereich einer Ausgestaltung einer Vorrichtung gemäß der vorliegenden Erfindung;
Fig. 4 einen vierten, optionalen Teilbereich einer Ausgestaltung einer Vorrichtung gemäß der vorliegenden Erfindung;
Fig. 5 eine Ausgestaltung einer ersten Vorstufe einer Druckplatte für den wasserlosen Offsetdruck;
Fig. 6 eine Ausgestaltung einer weiteren Vorstufe einer Druckplatte für den wasserlosen Offsetdruck;
Fig. 7 eine Ausgestaltung einer weiteren Vorstufe einer Druckplatte für den wasserlosen Offsetdruck;
Fig. 8 eine Ausgestaltung einer fertiggestellten Druckplatte für den wasserlosen Offsetdruck;
Fig. 9 eine Detailansicht einer Bürste einer Bürsteinheit für eine erfindungsgemäße Vorrichtung; und
Fig. 10 eine Ansicht darstellend ein Herstellungsverfahren für eine Bürste für eine erfindungsgemäße Vorrichtung.

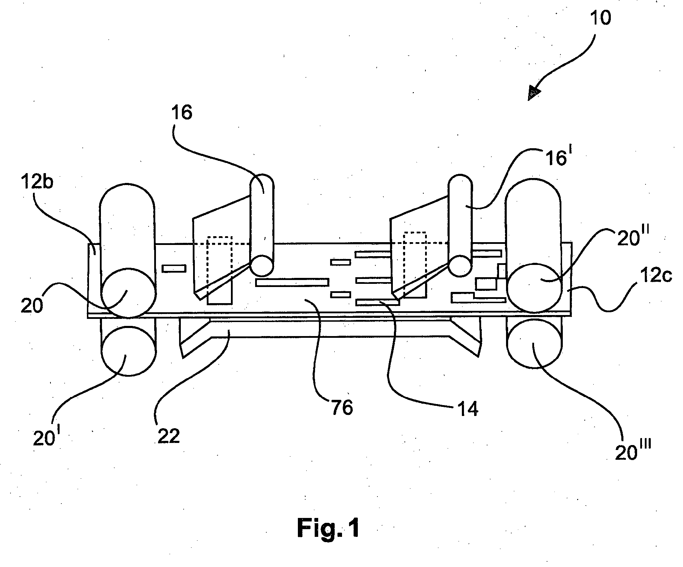

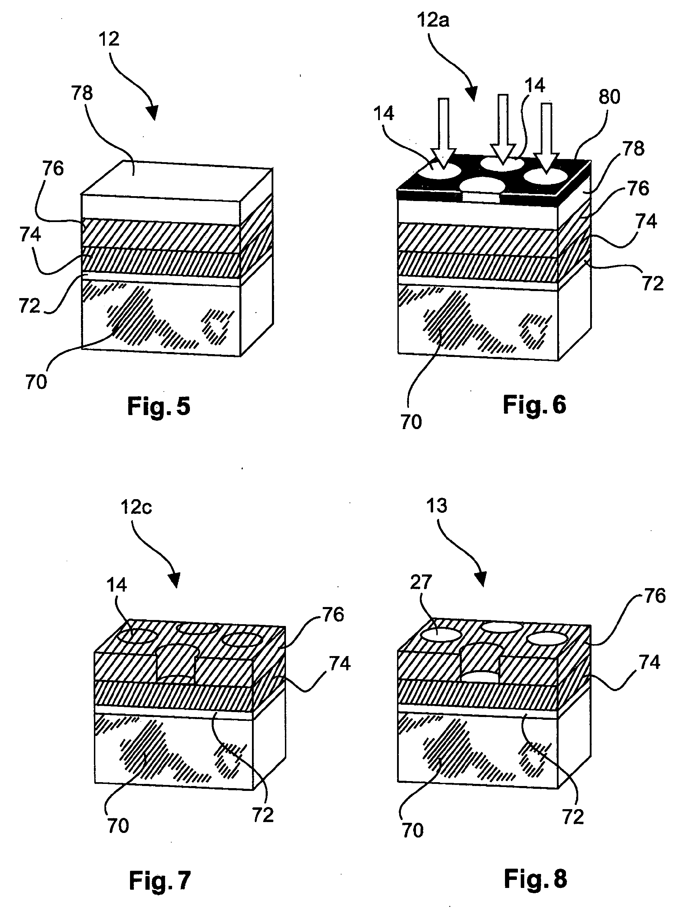

In der Figur 1 ist ein einen erster, optionaler Teilbereich einer Ausgestaltung einer Vorrichtung gemäß der vorliegenden Erfindung gezeigt. Dabei ist in der Figur 1 eine Vorbehandlungseinheit 10 gezeigt, in welcher die Druckplatten-Vorstufe 12_{b}, wie diese mit Bezug auf die Figuren 5 bis 8 im Detail beschrieben wird, einer Vorbehandlung unterzogen wird. Dabei können insbesondere herauszulösende Bereiche 14 der Druckplatten-Vorstufe 12_{b} durch Auftragevorrichtungen 16, 16' mit einem Quellmittel beziehungsweise Aufquellmittel behandelt werden, wobei die Druckplatten-Vorstufe 12_{c} entsteht. Dabei können die herauszulösenden Bereiche 14 in einer Silikonbeschichtung 76 vorliegen und definiert werden durch eine auf der Druckplatten-Vorstufe 12ₐ befindliche Maske 80, wie dies nachfolgend beschrieben wird. Es ist ferner gezeigt, dass eine Transportvorrichtung zum Durchführen der Druckplatten-Vorstufe 12_{b} durch die Vorbehandlungseinheit 10 vorgesehen ist, welche Walzen 20, 20', 20", 20'" sowie eine Auflage 22 aufweist.

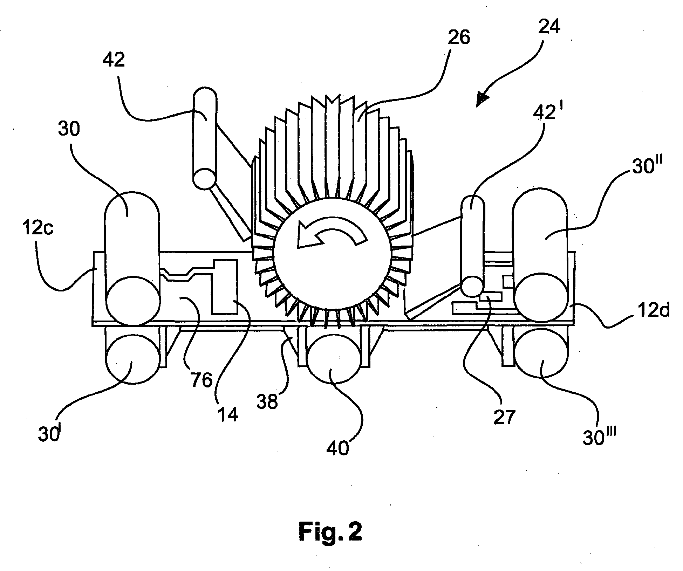

In der Figur 2 ist ein weiterer Teilbereich einer Ausgestaltung einer Vorrichtung gemäß der vorliegenden Erfindung gezeigt. Dabei ist in der Figur 2 eine Bürsteinheit 24 gezeigt, in welcher die gegebenenfalls in der Vorbehandlungseinheit 10 vorbehandelten herauszulösenden Bereiche 14 durch eine Bürste 26 herausgelöst werden. Dabei dient die Silikonbeschichtung 76 als Deckschicht, welche durch die Bürste 26 behandelt wird.

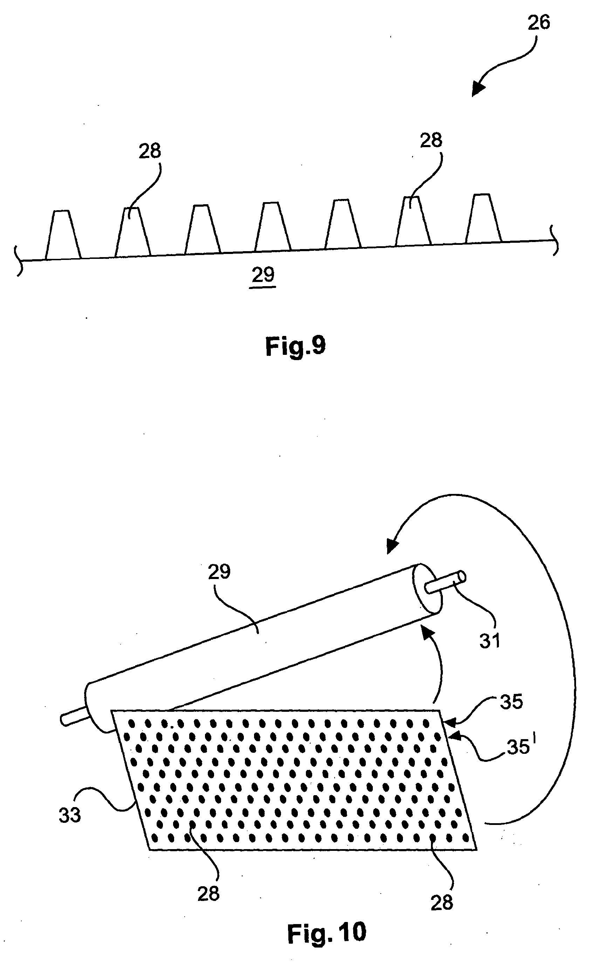

Die Bürste 26 ist im Detail in der Figur 9 gezeigt. Dabei ist in der Figur 9 zu sehen, dass die Bürste 26 eine Vielzahl an Borsten 28 aufweist, die eine noppenartige und dabei insbesondere eine kegelartige Struktur aufweisen. Dabei sind die Borsten 28 auf einem insbesondere zylindrischen Grundkörper 29 angeordnet, der durch eine Welle 31 rotierbar gelagert sein kann.

Ein mögliches Herstellungsverfahren für eine derartigen Bürste 26 ist in der Figur 10 gezeigt. Gemäß Figur 10 kann eine Noppenmatte 33, welche auf ihrer Oberfläche mit der Vielzahl an Borsten 28 versehen ist, derart um den Grundkörper 29 gelegt werden, dass die Borsten 28 nach außen freiliegen, wie dies durch die Pfeile der Figur 10 angedeutet ist. Ferner kann die Noppenmatte 33 in dieser Position befestigt werden. Gemäß Figur 10 ist es dabei beispielhaft aber nicht beschränkend bei der Verwendung einer Noppenmatte 33 vorgesehen, dass die Borsten 28 in einer Mehrzahl von in Laufrichtung hintereinander positionierten Reihen 35, 35' angeordnet sind, wobei die Borsten 28 in jeder Reihe zumindest teilweise den gleichen Abstand zueinander aufweisen, und wobei zwei in Laufrichtung der Borsten 28, also in einer Rotationsrichtung der Bürste 26, aufeinanderfolgende Reihen 35, 35' axial zueinander versetzt sind. Dabei können sämtliche Borsten 28 in einer Reihe 35 zueinander den gleichen Abstand aufweisen, oder randseitige Borsten 28 können beispielsweise einen abweichenden Abstand aufweisen, wobei der Abstand zwischen den Borsten 28 in den verschiedenen Reihen 35, 35' in den entsprechenden Reihen 35, 35' gleich sein kann. Dabei kann ein beliebig variierender axialer Versatz der Reihen 35 zueinander vorliegen, um so eine besonders große räumliche Abdeckung in axialer Richtung bei einer Rotation der Bürste 26 zu ermöglichen. Beispielsweise kann ein Versatz in einem Bereich von ≥ 1mm bis ≤ 3mm, etwa von 2mm, vorliegen. Beispielsweise können die Borsten 28 zu der Laufrichtung der Borsten 28 die Reihen 35, 35' übergreifend eine diagonale Ausrichtung aufweisen.

Zurückkommend auf Figur 2 ist weiterhin eine Transportvorrichtung zum Durchführen der Druckplatten-Vorstufe 12_{c} durch die Bürsteinheit 24 vorgesehen, welche Walzen 30, 30', 30", 30'" sowie eine Auflage 38 aufweist, wobei ferner eine Gegenwalze 40 vorgesehen ist, welche auf der der Bürste 26 entgegengesetzt angeordneten Seite der Druckplatten-Vorstufe 12_{c} positioniert ist, um so ein besonders effektives entfernen des herauszulösenden Materials zu ermöglichen. Ferner sind zum Abspülen beziehungsweise Abtransportieren des herausgelösten Materials Eintragsvorrichtungen 42, 42' vorgesehen, durch welche der Herauslöseprozess durch Einwirkung von Wasser unterstützt werden kann. Stromabwärts der Bürste 26 sind aus den Bereichen 14 durch das Herauslösen des Materials Aussparungen 27 in der Druckplatten-Vorstufe 12_{d} entstanden.

An die Bürsteinheit 24 anschließend kann eine weitere, nicht gezeigte, Bürsteinheit vorgesehen sein, welche ein weiteres bürstendes Behandeln der herauszulösenden Bereiche 14 erlaubt. Dabei kann die Bürste der nicht gezeigten Bürsteinheit beispielsweise eine zu der in Figur 2 gezeigten Drehrichtung umgekehrte Drehrichtung aufweisen.

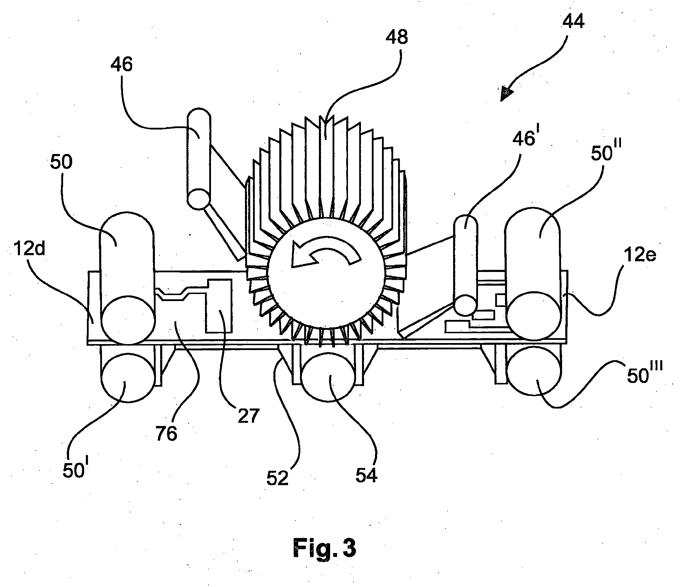

In der Figur 3 ist ein weiterer, optionaler Teilbereich einer Ausgestaltung einer Vorrichtung gemäß der vorliegenden Erfindung gezeigt. Dabei ist in der Figur 3 eine Nachbehandlungseinheit 44 gezeigt, in welcher die Druckplatten-Vorstufe 12_{d} einer Nachbehandlung unterzogen wird. Dabei kann die Nachbehandlung etwa umfassen ein Einarbeiten von durch Auftrageinheiten 46, 46' aufgetragener Farbe mittels einer rotierenden Bürste 48, um das Druckbild sichtbar zu machen. Dabei entsteht die Druckplatten-Vorstufe 12ₑ. Es kann ferner eine Transportvorrichtung zum Durchführen der Druckplatten-Vorstufe 12_{d} durch die Nachbehandlungseinheit 44 vorgesehen sein, welche Walzen 50, 50', 50", 50"' sowie eine Auflage 52 aufweist, wobei ferner eine Gegenwalze 54 vorgesehen ist, welche auf der der Bürste 48 entgegengesetzt angeordneten Seite der Druckplatten-Vorstufe 12 positioniert ist.

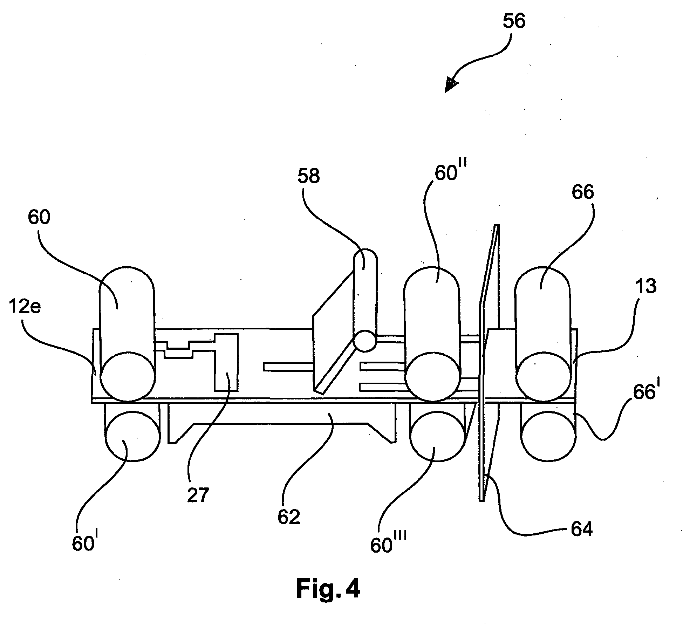

In der Figur 4 ist ein weiterer, optionaler Teilbereich einer Ausgestaltung einer Vorrichtung gemäß der vorliegenden Erfindung gezeigt. Dabei ist in der Figur 4 eine Finalisierungseinheit 56 gezeigt, wobei diese eine Sprüheinheit 58, etwa zum Aufsprühen von Wasser oder anderen Lösungsmitteln, aufweist, um letzte Verunreinigungen, wie etwa Farbreste, zu entfernen. Es kann ferner eine Transportvorrichtung zum Durchführen der Druckplatten-Vorstufe 12ₑ durch die Finalisierungseinheit 56 vorgesehen sein, welche Walzen 60, 60', 60", 60'" sowie eine Auflage 62 aufweist. Etwa durch eine Abtrennung 64 von der Sprüheinheit 58 getrennt können ferner Walzen 66, 66' vorgesehen sein, um die Druckplatte abzuquetschen beziehungsweise die Feuchtigkeit zu entfernen. Im Anschluss an die Walzen 66, 66' kann die Druckplatte 13 fertig gestellt sein.

In der Figur 5 ist ferner zum besseren Verständnis eine Druckplatten-Vorstufe 12 gezeigt. Diese Vorstufe 12 umfasst einen Träger 70, wie etwa einen Aluminium-Träger, auf dem mittels einer Primer-Schicht 72 eine in einem Druckverfahren farbtragende beziehungsweise farbaffine Schicht 74 angeordnet ist, welche beispielsweise und nicht beschränkend eine Schicht umfassend ein Diazoniumsalz-Polykondensationsprodukt sein kann. Oberhalb der farbaffinen Schicht ist eine Silikon-Beschichtung 76 vorgesehen, welche durch eine Schutzschicht 78 geschützt sein kann.

In der Figur 6 ist eine weitere Druckplatten-Vorstufe 12ₐ gezeigt, welche auf der Schutzschicht 78 eine Maskierung 80 trägt. Durch die Maskierung 80 können herauszulösende Bereiche 14 definiert werden, aus denen das Material der Silikon-Beschichtung 76 herausgelöst werden soll. Um dies vorteilhaft zu realisieren, kann die Druckplatten-Vorstufe 12ₐ mit einer Strahlung, wie beispielsweise mit UV-Strahlung bestrahlt werden, wie dies durch die Pfeile in der Figur 6 angedeutet werden soll und welche nach der Bestrahlung und nach dem Entfernen der Maske 80 und der Schutzschicht 78 als Druckplatten-Vorstufe 12_{b} in eine in Figur 1 gezeigte Vorbehandlungseinheit 10 eingeführt und dort mit einem Aufquellmittel versehen werden kann.

In der Figur 7 ist die Druckplatten-Vorstufe 12_{c} gezeigt, welche insbesondere einer Vorbehandlungseinheit 10 entnommen werden kann und welche einer Bürsteinheit 24 zugeführt werden kann. In der Druckplatten-Vorstufe 12_{c} gemäß Figur 7 sind die herauszulösenden Bereiche 14 vorbehandelt und können durch die Bürste 26 von dem herauszulösenden Material befreit werden.

Figur 8 zeigt eine fertiggestellte Druckplatte 13 für den wasserlosen Offsetdruck, wobei druckende Bereiche durch die ausgebildeten Aussparungen 27 definiert sind und nicht druckende Bereiche durch die vorhandene Silikonbeschichtung 76 definiert sind.

## Patentansprüche

1. Vorrichtung zum Herstellen einer Druckplatte (13) für den wasserlosen Offsetdruck, aufweisend eine Bürsteinheit (24) zum bürstenden Herauslösen von herauszulösenden Bereichen (14) einer Beschichtung einer Druckplatten-Vorstufe (12_{c}), wobei die Bürsteinheit (24) wenigstens eine Bürste (26) mit einer Vielzahl von Borsten (28) aufweist, **dadurch gekennzeichnet, dass** die Borsten (28) aus Silikon ausgestaltet sind und eine noppenartige Struktur aufweisen.

2. Vorrichtung nach Anspruch 1, **dadurch gekennzeichnet, dass** die Borsten (28) in einer Mehrzahl von in Laufrichtung der Borsten (28) hintereinander positionierten Reihen (35, 35') angeordnet sind, wobei die Borsten (28) in jeder Reihe (35, 35') zumindest teilweise einen gleichen Abstand zueinander aufweisen, und wobei zwei in Laufrichtung aufeinanderfolgende Reihen (35, 35') axial versetzt sind.

3. Vorrichtung nach Anspruch 1 oder 2, **dadurch gekennzeichnet, dass** die Borsten (28) eine kegelartige Struktur aufweisen.

4. Vorrichtung nach einem der Ansprüche 1 bis 3, **dadurch gekennzeichnet, dass** die Borsten (28) eine Shore-A-Härte in einem Bereich von ≥ 50 aufweisen.

5. Vorrichtung-nach einem der Ansprüche 1 bis 4, **dadurch gekennzeichnet, dass** die Borsten (28) eine Länge in einem Bereich von ≥ 3mm bis ≤ 20mm aufweisen.

6. Vorrichtung nach einem der Ansprüche 1 bis 5, dadurch gekenntzeichnet, dass die Borsten (28) in einer Anzahl von ≥ 40000/m² bis ≤ 150000/m² vorgesehen sind.

7. Verfahren zum Herstellen einer Druckplatte (13) für den wasserlosen Offsetdruck, aufweisend die Verfahrensschritte:
a) Bereitstellen einer Druckplatten-Vorstufe (12_{c}), welche eine Beschichtung mit in der Beschichtung vorgesehenen herauszulösenden Bereichen (14) aufweist;
b) Einführen der Druckplatten-Vorstufe (12_{c}) in eine Bürsteinheit (24), wobei die Bürsteinheit (24) eine Bürste (26) mit einer Vielzahl von Borsten (28) umfasst, wobei die Borsten (28) aus Silikon ausgestaltet sind und eine noppenartige Struktur aufweisen; und
c) Bürstendes Behandeln der Druckplatten-Vorstufe (12_{c}) in der Bürsteneinheit (24) durch die wenigstens eine Bürste (26) zum Herauslösen des herauszulösenden Materials.

8. Verfahren nach Anspruch 7, **dadurch gekennzeichnet, dass** Verfahrensschritt a) die Verfahrensschritte aufweist:
a1) Bestrahlen definierter Bereiche der Beschichtung einer Druckplatten-Vorstufe (12ₐ) mit elektromagentischer Strahlung; und
a2) Behandeln der bestrahlten Bereiche mit einem Aufquellmittel.

9. Verfahren nach einem der Ansprüche 7 oder 8, **dadurch gekennzeichnet, dass** die Bürste (26) während Verfahrensschritt c) axial bewegt wird.

10. Verwendung einer Bürste (26) mit einer Vielzahl an Borsten (28) zum bürstenden Behandeln einer Druckplatten-Vorstufe (12_{c}) zum Entfernen von Material aus herauszulösenden Bereichen (14) einer Beschichtung im Rahmen einer Herstellung von Druckplatten (13) für den wasserlosen Offsetdruck, **dadurch gekennzeichnet, dass** eine Bürste (26) verwendet wird, deren Borsten (28) aus Silikon ausgestaltet sind und eine noppenartige Struktur aufweisen.

## Claims

1. Apparatus for producing a printing plate (13) for waterless offset printing, comprising a brushing unit (24) for removing regions (14) to be removed from a coating of a printing plate precursor (12_{c}) by brushing, wherein the brushing unit (24) includes at least one brush (26) comprising a plurality of bristles (28), **characterized in that** the bristles (28) are formed of silicone and have a nub-like structure.

2. Apparatus according to claim 1, **characterized in that** the bristles (28) are arranged in a plurality of rows (35, 35') disposed in succession in the moving direction of the bristles (28), wherein the bristles (28) of each row (35, 35') are spaced at least partially uniformly from each other, and wherein two rows (35, 35') disposed in succession in the moving direction are axially offset.

3. Apparatus according to claim 1 or 2, **characterized in that** the bristles (28) have a conical structure.

4. Apparatus according to any one of claims 1 to 3, **characterized in that** the bristles (28) have a Shore hardness A in the range of ≥ 50.

5. Apparatus according to any one of claims 1 to 4, **characterized in that** the bristles (28) have a length in the range of ≥ 3 mm to ≤ 20 mm.

6. Apparatus according to any one of claims 1 to 5, **characterized in that** the bristles (28) are provided in a number of ≥ 40.000/m² to ≤ 150.000/m².

7. Method for producing a printing plate (13) for waterless offset printing, comprising the process steps:
a) providing a printing plate precursor (12_{c}) comprising a coating with regions (14) to be removed provided within the coating;
b) introducing the printing plate precursor (12_{c}) into a brushing unit (24), wherein the brushing unit (24) includes a brush (26) comprising a plurality of bristles (28), wherein the bristles (28) are formed of silicone and have a nub-like structure; and
c) treating the printing plate precursor (12_{c}) within the brushing unit (24) by brushing by use of the at least one brush (26) for removing the material to be removed.

8. Method according to claim 7, **characterized in that** process step a) comprises the process steps:
a1) irradiating defined regions of the coating of a printing plate precursor (12ₐ) with electromagnetic radiation; and
a2) treating the irradiated regions with a swelling agent.

9. Method according to claim 7 or 8, **characterized in that** the brush (26) is axially moved during process step c).

10. Use of a brush (26) comprising a plurality of bristles (28) for treating a printing plate precursor (12_{c}) by brushing for removing material from regions (14) to be removed of a coating in the course of the production of printing plates (13) for waterless offset printing, **characterized in that** a brush (26) is used which comprises bristles (28) which are formed of silicone and have a nub-like structure.

## Revendications

1. Dispositif de fabrication d'une plaque d'impression (13) pour l'impression offset sans eau, présentant une unité de brossage (24) pour un lessivage par brossage de régions devant être lessivées (14) d'un revêtement d'un précurseur de plaque d'impression (12_{c}), où l'unité de brossage (24) présente au moins une brosse (26) avec un grand nombre de soies (28), **caractérisé en ce que** les soies (28) sont façonnées en silicone et présentent une structure en forme de bosses.

2. Dispositif selon la revendication 1, **caractérisé en ce que** les soies (28) sont disposées en un nombre multiple de rangées (35, 35') positionnées les unes derrière les autres dans la direction de déplacement des soies (28), où les soies (28) dans chaque rangée (35, 35') présentent au moins partiellement une même distance les unes par rapport aux autres, et où deux rangées (35, 35') se succédant dans la direction de déplacement sont décalées axialement.

3. Dispositif selon la revendication 1, ou 2, **caractérisé en ce que** les soies (28) présentent une structure en forme de cône.

4. Dispositif selon l'une des revendications 1 à 3, **caractérisé en ce que** les soies (28) présentent une dureté Shore A dans une plage ≥ 50.

5. Dispositif selon l'une des revendications 1 à 4, **caractérisé en ce que** les soies (28) présentent une longueur dans une plage ≥ 3 mm à ≤ 20 mm.

6. Dispositif selon l'une des revendications 1 à 5, **caractérisé en ce que** les soies (28) sont prévues à une quantité ≥ 40000/m² à ≤ 150000/m².

7. Procédé de fabrication d'une plaque d'impression (13) pour une impression offset sans eau, présentant les étapes de procédé :
a) mise en place d'un précurseur de plaque d'impression (12_{c}), lequel présente un revêtement avec des régions devant être lessivées (14) prévues dans le revêtement ;
b) introduction du précurseur de plaque d'impression (12_{c}) dans une unité de brossage (24), où l'unité de brossage (24) comprend une brosse (26) avec un grand nombre de soies (28), où les soies (28) sont façonnées en silicone et présentent une structure en forme de bosses ; et
c) le traitement par brossage du précurseur de plaque d'impression (12_{c}) dans l'unité de brossage (24) par au moins une brosse (26) pour le lessivage du matériau à lessiver.

8. Procédé selon la revendication 7, **caractérisé en ce que** l'étape de procédé a) présente les étapes de procédé :
a1) irradiation de régions définies du revêtement d'un précurseur de plaque d'impression (12_{c}) avec un rayonnement électromagnétique ; et
a2) traitement des régions irradiées avec un agent gonflant.

9. Procédé selon l'une des revendications 7 ou 8, **caractérisé en ce que** la brosse (26) est déplacée axialement durant l'étape de procédé c).

10. Utilisation d'une brosse (26) avec un grand nombre de soies (28) pour le traitement par brossage d'un précurseur de plaque d'impression 12_{c}) pour le retrait de matériau dans des régions à lessiver (14) d'un revêtement dans le cadre d'une fabrication de plaques d'impression (13) pour l'impression offset sans eau, **caractérisée en ce qu'**une brosse (26) est utilisée, dont les soies (28) sont façonnées en silicone et présentent une structure en forme de bosses.
